# EUROPEAN PATENT APPLICATION

(11) **EP 4 161 232 A1**
(43) Date of publication of application: **05.04.2023**
(21) Application number: 21817673.3
(22) Date of filing: 02.06.2021
(51) Int. Cl.: H05K 9/00, B32B 7/025

(54) **RADIO WAVE ABSORBER**

(30) Priority: 02.06.2020 JP 2020096038
(71) Applicant: SEKISUI CHEMICAL CO., LTD., Osaka-shi Osaka 530-8565 (JP)
(72) Inventor: NAKAO, Sachiko, Gamagori-shi, Aichi 443-8623 (JP); SAWADAISHI, Tetsurou, Gamagori-shi, Aichi 443-8623 (JP); MUTOU, Katsunori, Gamagori-shi, Aichi 443-8623 (JP)
(74) Representative: Ter Meer Steinmeister & Partner
(86) International application number: PCT/JP2021/020981
(87) International publication number: WO 2021/246438

(57) **Abstract**

An object of the present invention is to provide a radio wave absorber having durability against corrosive gases. The invention provides a radio wave absorber comprising a base material, a dielectric layer, and a reflective layer, the base material, the dielectric layer, and the reflective layer being stacked in this order, the base material having a water vapor transmission rate of 5 g/(m²•day) or less, the reflective layer having a resistance value after a flowing mixed gas corrosion test of 100 Ω/□ or less.

## Description

### Technical Field

The present invention relates to a radio wave absorber and related items.

### Background Art

Mobile communication devices such as cellular phones and smartphones have rapidly become widespread. Automobiles, for example, have been equipped with many electronic devices; however, due to radio waves and noise generated from these devices, radio disturbances or malfunctions of other electronic devices frequently occur. To prevent these problems, such as radio disturbances and malfunctions, various radio wave absorbers have been studied. For example, PTL 1 discloses an electromagnetic wave absorber that has a bandwidth of 2 GHz or more in a frequency band of which the absorption of electromagnetic waves is 20 dB or more within the frequency band of 60 to 90 GHz.

### Citation List

### Patent Literature

PTL 1: JP2018-098367A

### Summary of Invention

### Technical Problem

Given the rapid proliferation of automated driving technologies, there is a growing demand for millimeter-wave absorbers for controlling electromagnetic sensors. For example, millimeter-wave absorbers installed in electromagnetic sensors in automobiles must work with high precision even under conditions of high temperatures, low temperatures, and high humidity, to which automobiles may be exposed, as well as in environments of corrosive gas, such as sulfide gas generated in hot-spring areas.

An object of the present invention is to provide a radio wave absorber having durability against corrosive gases.

### Solution to Problem

As a result of extensive research in view of the above object, the present inventors found that a radio wave absorber comprising a base material, a dielectric layer, and a reflective layer, the base material, the dielectric layer, and the reflective layer being stacked in this order, the base material having a water vapor transmission rate of 5 g/(m²•day) or less, and the reflective layer having a resistance value after a flowing mixed gas corrosion test of 100 Ω/□ or less, can achieve the above object. Based on this finding, the present inventors conducted further research and accomplished the present invention. More specifically, the present invention encompasses the following embodiments.

1. A radio wave absorber comprising a base material, a dielectric layer, and a reflective layer,
   the base material, the dielectric layer, and the reflective layer being stacked in this order,
   the base material having a water vapor transmission rate of 5 g/ (m²•day) or less,
   the reflective layer having a resistance value after a flowing mixed gas corrosion test of 100 Ω/□ or less.
2. The radio wave absorber according to Item 1, wherein the base material comprises a support and a barrier layer, and wherein the barrier layer is disposed between the support and the dielectric layer.
3. The radio wave absorber according to Item 1 or 2, wherein the reflective layer has a thickness of 8 µm or more.
4. The radio wave absorber according to any one of Items 1 to 3, wherein the reflective layer contains at least one metal selected from the group consisting of nickel, chromium, molybdenum, and tantalum.
5. The radio wave absorber according to any one of Items 1 to 4, wherein the absorption of electromagnetic waves at 79 GHz after a flowing mixed gas corrosion test is 20 dB or more.
6. The radio wave absorber according to any one of Items 1 to 5, which further comprises a resistive film and is a λ/4 type radio wave absorber.
7. The radio wave absorber according to Item 6, wherein the base material, the resistive film, the dielectric layer, and the reflective layer are stacked in this order.
8. The radio wave absorber according to any one of Items 1 to 5, wherein the dielectric layer contains magnetic particles.
9. A molded product equipped with a radio wave absorber, comprising the radio wave absorber of any one of Items 1 to 8.
10. A millimeter-wave radar comprising the radio wave absorber of any one of Items 1 to 8.

### Advantageous Effects of Invention

The present invention can provide a radio wave absorber having durability against corrosive gases.

### Brief Description of Drawings

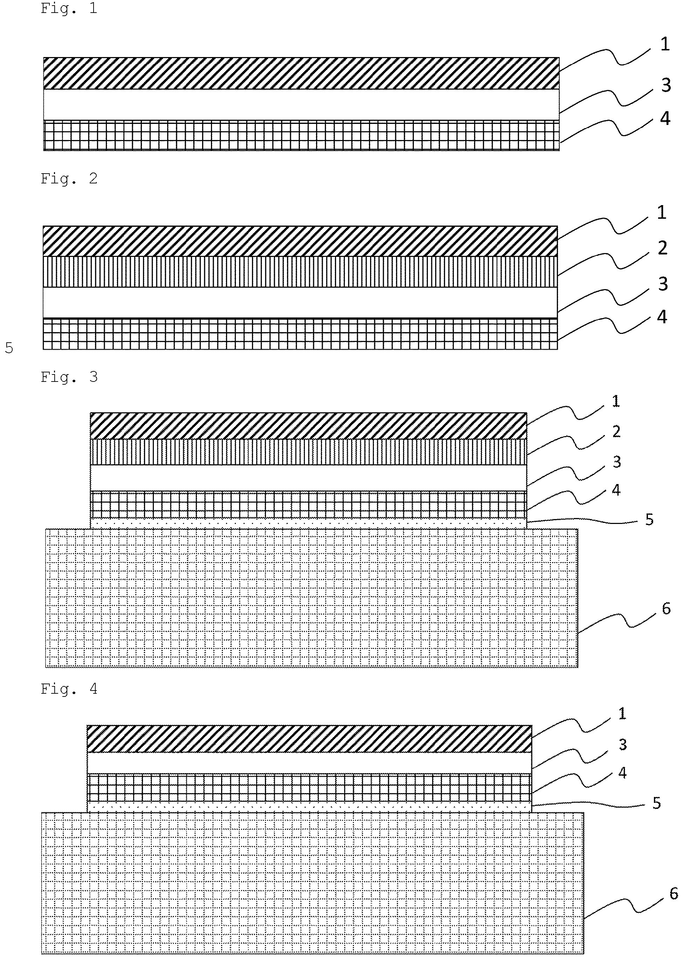

Fig. 1 illustrates the schematic cross-section of the radio wave absorber according to an embodiment of the present invention.
Fig. 2 illustrates the schematic cross-section of the radio wave absorber according to an embodiment of the present invention.
Fig. 3 illustrates a schematic cross section that illustrates an application of the radio wave absorber according to an embodiment of the present invention. (In this embodiment, the radio wave absorber is disposed on a molded product through an adhesive.)
Fig. 4 illustrates a schematic cross section that illustrates an application of the radio wave absorber according to an embodiment of the present invention. (In this embodiment, the radio wave absorber is disposed on a molded product through an adhesive.)

### Description of Embodiments

In the present specification, the terms "comprise," "contain," and "include" include the concepts of comprising, containing, including, consisting essentially of, and consisting of.

### 1. Radio Wave Absorber

In one embodiment, the present invention relates to a radio wave absorber comprising a base material, a dielectric layer, and a reflective layer, the base material, the dielectric layer, and the reflective layer being stacked in this order, the base material having a water vapor transmission rate of 5 g/(m²•day) or less, and the reflective layer having a resistance value after a flowing mixed gas corrosion test of 100 Ω/□ or less (which may be referred to in the present specification as "the radio wave absorber of the present invention"). The details are explained below.

### 1-1. Base Material

The base material is characterized by having a water vapor transmission rate of 5 g/(m²•day) or less. The base material having this characteristic can prevent corrosive gases from entering the radio wave absorber. Furthermore, the characteristic above in combination with the characteristic of the reflective layer described below can achieve durability against corrosive gases.

The water vapor transmission rate is 5 g/(m²•day) or less, preferably 3 g/(m²•day) or less, and more preferably 2 g/(m²•day) or less. The lower limit of the water vapor transmission rate can be any value, and may be, for example, 1 × 10⁻² g/ (m²•day) or 1 × 10⁻¹ g/ (m²•day).

The water vapor transmission rate can be measured as follows. Specifically, a water vapor transmission test is performed using a PERMATRAN-W 3/33 water vapor transmission rate testing system (produced by Mocon, Inc.; or an equivalent product). The measurement can be performed by a method according to JIS K7129:2019 at a test temperature of 40°C and a test humidity of 90% RH, with the adhesive surface side being on the detector side.

The base material may be any base material that has the above characteristic. From the standpoint of durability etc., the base material may comprise, for example, a support. Furthermore, to satisfy the above characteristic, the base material preferably comprises a barrier layer. In a preferred embodiment of the present invention, the base material comprises a support and a barrier layer. In this embodiment, it is more preferred that the barrier layer be disposed between the support and the dielectric layer (i.e., disposed on the surface of the support on the dielectric layer side).

### 1-1-1. Support

The support can increases the durability of the radio wave absorber. The support may be any support in sheet form. Examples of the support include, but are not limited to, a resin base material.

The resin base material may be any resin base material in sheet form that contains resin as a material. The resin base material may contain components other than resin, to the extent that the effect of the present invention is not significantly impaired. For example, from the standpoint of adjusting relative permittivity, the resin base material may contain particles of a metal oxide (e.g., titanium oxide) etc. The total amount of resin in the resin base material is, for example, 80 mass% or more, preferably 90 mass% or more, more preferably 95 mass% or more, and still more preferably 99 mass% or more; and typically less than 100 mass%.

Examples of resins include, but are not limited to, polyester-based resins, such as polyethylene terephthalate (PET), polyethylene naphthalate, and modified polyester; polyolefin resins, such as polyethylene (PE) resin, polypropylene (PP) resin, polystyrene resin, and cyclic olefin-based resins; vinyl-based resins, such as polyvinyl chloride and polyvinylidene chloride; polyvinyl acetal resins, such as polyvinyl butyral (PVB); polyether ether ketone (PEEK) resin, polysulfone (PSF) resin, polyether sulfone (PES) resin, polycarbonate (PC) resin, polyamide resin, polyimide resin, acrylic resin, and triacetyl cellulose (TAC) resin. These resins can be used singly or in a combination of two or more.

Of these, from the standpoint of productivity and strength, polyester-based resins are preferable, and polyethylene terephthalate is more preferable.

The relative permittivity of the support can be any value. The relative permittivity of the support is, for example, 1 to 20, preferably 1 to 15, more preferably 1 to 10, and still more preferably 1 to 5.

The relative permittivity of the support can be measured in the same manner as the relative permittivity of the dielectric layer described below.

The thickness of the support may be any value. The lower limit of the thickness of the support is, for example, 5 µm, preferably 10 µm, and more preferably 20 µm. When the thickness of the support is 5 um or more, the water vapor transmission rate of the radio wave absorber is easily adjusted to 5 g/(m²•day) or less. The upper limit of the thickness of the support is, for example, 500 µm, and preferably 300 µm. When the thickness of the support is 500 um or less, the radio wave absorption is easily controlled. Further, the radio wave absorber can be designed to be lightweight.

The layer structure of the support is not particularly limited. The support may be composed of a single support, or a combination of two or more supports.

### 1-1-2. Barrier Layer of Base Material

The barrier layer is disposed on at least one surface of the support. As described above, the barrier layer is preferably disposed between the support and the dielectric layer (i.e., disposed on the surface of the support on the dielectric layer side). The barrier layer is described in detail below. The presence of the barrier layer makes it easy to adjust the water vapor transmission rate of the radio wave absorber to 5 g/(m²•day) or less.

The barrier layer may be any layer that has gas barrier properties. The material of the barrier layer can be, for example, a metal compound or a metalloid compound; and preferably, for example, an oxide, a nitride, or a nitride oxide of metal or metalloid. The barrier layer may contain components other than these materials, to the extent that the effect of the present invention is not significantly impaired. In this case, the content of the material described above in the barrier layer is, for example, 80 mass% or more, preferably 90 mass% or more, more preferably 95 mass% or more, and still more preferably 99 mass% or more; and typically less than 100 mass%.

Examples of metal elements contained in the barrier layer include titanium, aluminum, niobium, cobalt, and nickel. Examples of metalloid elements contained in the barrier layer include silicon, germanium, antimony, and bismuth.

Examples of the oxide above include compounds represented by MOx wherein X represents a number that satisfies the formula: n/100 ≤ X ≤ n/2 (n representing the valence of a metal or metalloid), and M represents a metal element or metalloid element.

Examples of the nitride above include compounds represented by MN_{Y} wherein Y represents a number that satisfies the formula: n/100 ≤ Y ≤ n/3 (n representing the valence of a metal or metalloid), and M represents a metal element or metalloid element.

Examples of the nitride oxide above include compounds represented by MO_{X}N_{Y} wherein X and Y satisfy the formula: n/100 ≤ X, n/100 ≤ Y, and X + Y ≤ n/2 (n representing the valence of a metal or metalloid), and M represents a metal element or metalloid element.

Regarding the oxidation number X of the oxide or nitride oxide, for example, elemental analysis of the cross-sectional surface of a layer containing MOx or MO_{X}N_{Y} is performed with an FE-TEM-EDX (e.g., JEM-ARM200F produced by JEOL, Ltd.), and then X is calculated from the element ratio of M and O per area of the cross-sectional surface of the layer containing MOx or MOxN_{Y}. From this calculation, the valence of the oxygen atom can be determined.

Regarding the nitridation number Y of the nitride or nitride oxide, for example, elemental analysis of the cross-sectional surface of a layer containing MN_{Y} or MO_{X}N_{Y} is performed with an FE-TEM-EDX (e.g., JEM-ARM200F produced by JEOL, Ltd.), and then Y is calculated from the element ratio of M and N per area of the cross-sectional surface of the layer containing MN_{Y} or MOxN_{Y}. From this calculation, the valence of the nitrogen atom can be determined.

Specific examples of materials of the barrier layer include SiO₂, SiOₓ, Al₂O₃, MgAl₂O₄, CuO, CuN, TiO₂, TiN, and AZO (aluminum-doped zinc oxide).

The thickness of the barrier layer can be any value. The lower limit of the thickness of the barrier layer is, for example, 1 nm, preferably 3 nm, and more preferably 5 nm. When the thickness of the barrier layer is 1 nm or more, the water vapor transmission rate of the radio wave absorber is easily adjusted to 5 g/(m²•day) or less. The upper limit of the thickness of the barrier layer is, for example, 100 nm, preferably 50 nm, and more preferably 30 nm. When the thickness of the barrier layer is 100 nm or less, the radio wave absorption is easily controlled.

The layer structure of the barrier layer is not particularly limited. The barrier layer may be composed of a single barrier layer, or a combination of two or more barrier layers.

### 1-2. Dielectric Layer

The dielectric layer can be any dielectric layer that can function as a dielectric for a target wavelength in a radio wave absorber. Examples of dielectric layers include, but are not limited to, adhesive layers, resin sheets, and foam layers.

The adhesive layer can be any adhesive layer that contains an adhesive. The adhesive layer may contain components other than adhesives, to the extent that the effect of the present invention is not significantly impaired. In this case, the total amount of adhesive in the adhesive layer is, for example, 50 mass% or more, preferably 70 mass% or more, more preferably 90 mass% or more, and still more preferably 95 mass% or more; and typically less than 100 mass%.

Examples of adhesives include, but are not particularly limited to, acrylic adhesives, urethane adhesives, polyolefin adhesives, polyester adhesives, vinyl alkyl ether adhesives, polyamide adhesives, rubber adhesives, silicone adhesives, and fluorine-containing adhesive. Of these, acrylic adhesives are preferred from the standpoint of excellent weather resistance.

The resin sheet can be any sheet that contains resin as a material. The resin sheet may contain components other than resin, to the extent that the effect of the present invention is not significantly impaired. In this case, the total amount of resin in the resin sheet is, for example, 50 mass% or more, preferably 70 mass% or more, more preferably 90 mass% or more, and still more preferably 95 mass% or more; and typically less than 100 mass%.

The resin can be any resin, and the resin for use as a resin component is, for example, preferably a synthetic resin, such as ethylene vinyl acetate copolymers (EVA), vinyl chloride, urethane, acrylic, acrylic urethane, polyolefin, polyethylene, polypropylene, silicone, polyethylene terephthalate, polyester, polystyrene, polyimide, polycarbonate, polyamide, polysulfone, polyethersulfone, and epoxy; and a synthetic rubber material, such as polyisoprene rubber, polystyrene-butadiene rubber, polybutadiene rubber, chloroprene rubber, acrylonitrile-butadiene rubber, butyl rubber, acrylic rubber, ethylene-propylene rubber, and silicone rubber. These resins can be used singly or in a combination of two or more.

The dielectric layer may have adhesiveness. Thus, when a dielectric with no adhesiveness is stacked on another layer through an adhesive layer, the combination of the dielectric and the adhesive layer forms a dielectric layer. From the standpoint of ease of stacking a dielectric layer on an adjacent layer, the dielectric layer preferably contains an adhesive layer.

The relative permittivity of the dielectric layer can be any value. The relative permittivity of the dielectric layer is, for example, 1 to 20. When the radio wave absorber of the present invention is used as a radio wave absorber that uses magnetic loss (specifically, when not comprising the resistive film described below), the relative permittivity is preferably 1 to 15, more preferably 1 to 12, and still more preferably 2 to 10. When the radio wave absorber of the present invention is used as a λ/4 type radio wave absorber (specifically, when comprising the resistive film described below), the relative permittivity is preferably 1 to 15, more preferably 1 to 10, and still more preferably 1 to 5.

When the radio wave absorber of the present invention is used as a radio wave absorber that uses magnetic loss (specifically, when not comprising the resistive film described below), the dielectric layer preferably contains magnetic particles. This makes it easier to adjust the relative permittivity of the dielectric layer to be within a suitable range. Examples of magnetic particles include, but are not particularly limited to, particles of metal compounds, such as iron nitride, iron carbide, carbonyl iron, ferrite, magnetite, and ε-iron oxide; and particles of metals, such as iron, cobalt, and nickel.

The average particle size of the magnetic particles may be any value, and is preferably 0.001 to 800 µm, and more preferably 0.1 to 100 µm. The average particle size of the magnetic particles is measured by scanning electron microscopy.

The content of the magnetic particles may be any value, and is, for example, 50 to 500 parts by mass, preferably 70 to 450 parts by mass, and more preferably 100 to 400 parts by mass, per 100 parts by mass of the resin that constitutes the dielectric layer.

The relative permittivity of the dielectric layer can be determined by measuring relative permittivity at 10 GHz by a cavity perturbation method with, for example, a network analyzer or cavity resonator.

The thickness of the dielectric layer may be any value as long as radio wave absorption can be achieved. The thickness of the dielectric layer is, for example, 100 to 2000 um. When the radio wave absorber of the present invention is used as a radio wave absorber that uses magnetic loss (specifically, when not comprising the resistive film described below), the thickness is preferably 500 to 1700 µm, more preferably 800 to 1500 µm, still more preferably 1000 to 1400 µm, and even more preferably 1050 to 1350 um. When the radio wave absorber of the present invention is used as a λ/4 type radio wave absorber (specifically, when comprising the resistive film described below), the thickness is preferably 100 to 1000 µm, more preferably 200 to 800 µm, still more preferably 300 to 700 µm, and even more preferably 350 to 650 µm.

The thickness of the dielectric layer can be measured by a Nikon DIGIMICRO STAND MS-11C + Nikon DIGIMICRO MFC-101.

The layer structure of the dielectric layer is not particularly limited. The dielectric layer may be composed of a single dielectric layer, or a combination of two or more dielectric layers. Examples include a dielectric layer with a three-layered structure that includes a non-adhesive dielectric and adhesive layers disposed on both of the surfaces of the non-adhesive dielectric; and a dielectric layer with a monolayer structure that includes an adhesive dielectric.

### 1-3. Reflective Layer

The reflective layer can function as a reflective layer for radio waves in a radio wave absorber. The reflective layer is characterized by having a resistance value after a flowing mixed gas corrosion test of 100 Ω/□ or less. Due to this characteristic in combination with the characteristic of the base material described above, durability against corrosive gases can be exhibited. Further, when the radio wave absorber contains magnetic particles or a resistive film, this characteristic in combination with the characteristic of the base material described above can suppress corrosion of the magnetic particles or the resistive film, improving durability against corrosive gases. The characteristic can be controlled by any method, for example, by a method of adjusting the type of metal contained in the reflective layer, a method of adjusting the thickness of the reflective layer described below, or a method of adjusting the water vapor transmission rate of the base material described above.

The resistance value after a flowing mixed gas corrosion test is preferably 50 Ω/□ or less, more preferably 30 or less, and still more preferably 20 or less. The lower limit of the resistance value may be any value, and is, for example, 1 × 10⁻⁵ Ω/□ or 1 × 10⁻⁴ Ω/□. The flowing mixed gas corrosion test can be carried out as follows. Specifically, a sample is placed in the test chamber of a gas corrosion tester (KG120 (N), produced by Fact k Co., Ltd.; or an equivalent product thereof), and the test is carried out at a temperature of 35°C, a humidity of 75% RH, and a test duration of 240 hours by adjusting the gas concentrations, i.e., hydrogen sulfide: 0.1 ppm, sulfur dioxide: 2.0 ppm, nitrogen dioxide: 2.0 ppm, and chlorine: 0.1 ppm, based on Method 4 of IEC60068-2-60: 2015. The resistance value after the flowing mixed gas corrosion test can be measured as follows. Specifically, the resistance value after the flowing mixed gas corrosion test can be measured by an eddy current method using a non-contact resistance measurement instrument (trade name: EC-80P, produced by Napson Corporation; or an equivalent product).

Examples of reflective layers include, but are not limited to, metal films.

The metal film can be any metal film that contains metal as a material. The metal film may contain components other than metal, to the extent that the effect of the present invention is not significantly impaired. In this case, the total content of metal in the metal film is, for example 30 mass% or more, preferably 50 mass% or more, more preferably 75 mass% or more, still more preferably 80 mass% or more, yet more preferably 90 mass% or more, particularly preferably 95 mass% or more, and very preferably 99 mass% or more; and typically less than 100 mass%.

The metal can be any metal. Examples of metals include aluminum, copper, iron, silver, gold, nickel, chromium, molybdenum, tantalum, gallium, zinc, tin, niobium, and indium. Of these, nickel, chromium, molybdenum, tantalum, and the like are preferred from the standpoint of excellent stability against sulfide gas and ease of adjusting the characteristic of the reflective layer. Metal compounds, such as ITO, are also usable as a material of metal films. These metals can be used singly or in a combination of two or more.

The thickness of the reflective layer can be any value. The thickness of the reflective layer is, for example, 1 µm or more and 1000 µm or less. The thickness is preferably 5 µm or more, more preferably 8 µm or more, and still more preferably 10 µm or more from the standpoint of ease of adjusting the characteristic of the reflective layer. In this case, the upper limit of the thickness is not limited, and is, for example, 1000 µm or 500 µm.

The layer structure of the reflective layer is not particularly limited. The reflective layer may be composed of a single reflective layer, or a combination of two or more reflective layers.

### 1-4. Resistive Film

The radio wave absorber of the present invention can be used as both a radio wave absorber that uses magnetic loss and a λ/4 type radio wave absorber. In the latter, the radio wave absorber of the present invention further comprises a resistive film. The resistive film can be any resistive film that functions as a resistive layer in radio wave absorbers.

The resistance value of the resistive film can be any value. The resistance value (sheet resistance) of the resistive film is, for example, 100 Ω/□ or more and 800 Ω/□ or less. Within this range, the resistance value of the resistive film is more preferably 150 Ω/□ or more and 750 Ω/□ or less, and still more preferably 200 Ω/□ or more and 600 Ω/□ or less.

The resistance value of the resistive film can be measured by four-terminal sensing with a surface resistance tester (Loresta-EP, trade name, produced by Mitsubishi Chemical Analytech Co., Ltd.). When a dielectric etc. are stacked, and the resistance value of the resistive film cannot be directly measured, the surface of the support on the side opposite to the resistive film side can be measured by an eddy current method using a non-contact resistance measurement instrument (trade name: EC-80P, produced by Napson Corporation; or an equivalent product).

The thickness of the resistive film can be any value as long as the formed λ/4 type radio wave absorber has a resistance value that can achieve radio wave absorption. The thickness of the resistive film is, for example, 1 nm or more and 200 nm or less, preferably 2 nm or more and 100 nm or less, and more preferably 2 nm or more and 50 nm or less.

The layer structure of the resistive film is not particularly limited. The resistive film may be composed of a single layer, or a combination of two or more layers.

### 1-4-1. Resistive Layer

The resistance value of the resistive layer can be any value. The resistance value of the resistive layer is, for example, 100 Ω/□ or more and 800 Ω/□ or less. Within this range, the resistance value of the resistive layer is more preferably 150 Ω/□ or more and 750 Ω/□ or less, and still more preferably 200 Ω/□ or more and 600 Ω/□ or less.

The thickness of the resistive layer can be any value as long as the formed λ/4 type radio wave absorber has a resistance value that can achieve radio wave absorption. The thickness of the resistive layer is, for example, 1 nm or more and 200 nm or less, preferably 2 nm or more and 100 nm or less, and more preferably 2 nm or more and 50 nm or less.

The layer structure of the resistive layer is not particularly limited. The resistive layer may be composed of a single resistive layer, or a combination of two or more resistive layers.

### 1-4-1-1. Indium Oxide-containing Resistive Layer

Examples of resistive layers include resistive layers containing materials of resistive layers, such as indium oxide. In a preferred embodiment, the materials of resistive layers preferably contain materials in which other materials (dopants) are doped with indium oxide. Examples of other materials include, but are not particularly limited to, tin oxide and zinc oxide, and mixtures thereof.

Preferred examples of materials in which tin oxide is doped with indium oxide include tin oxide (IV) (SnO₂) doped with indium(III) oxide (In₂O₃) (indium tin oxide) (tin-doped indium oxide; ITO). From the standpoint of the highly stable amorphous structure and suppressed changes in sheet resistance of the resistive layer even in hot and humid conditions, the SnO₂ content in ITO is preferably 1 wt% or more and 40 wt% or less, and more preferably 2 wt% or more and 35 wt% or less.

The content of the above materials of resistive layers in the resistive layer is, for example, 50 mass% or more, preferably 70 mass% or more, more preferably 90 mass% or more, and still more preferably 95 mass% or more; and typically less than 100 mass%.

### 1-4-1-2. Molybdenum-containing Resistive Layer

The resistive layer for use preferably contains molybdenum from the standpoint of durability and ease of adjusting sheet resistance. The lower limit of the content of molybdenum is not particularly limited; from the standpoint of increasing durability, the lower limit of the content of molybdenum is preferably 5 wt%, more preferably 7 wt%, still more preferably 9 wt%, yet more preferably 11 wt%, particularly preferably 13 wt%, very preferably 15 wt%, and most preferably 16 wt%. The upper limit of the content of molybdenum is preferably 30 wt%, more preferably 25 wt%, and still more preferably 20 wt%, from the standpoint of ease of adjusting the surface resistance value.

More preferably, the resistive layer that contains molybdenum further contains nickel and chromium. A resistive layer containing nickel and chromium in addition to molybdenum leads to a radio wave absorber with excellent durability. Examples of alloys containing nickel, chromium, and molybdenum include a variety of alloy grades such as Hastelloy B-2, B-3, C-4, C-2000, C-22, C-276, G-30, N, W, and X.

The resistive layer containing molybdenum, nickel, and chromium preferably contains molybdenum in an amount of 5 wt% or more, nickel in an amount of 40 wt% or more, and chromium in an amount of 1 wt% or more. The resistive layer containing molybdenum, nickel, and chromium in amounts within these ranges leads to a radio wave absorber with further improved durability. The resistive layer more preferably contains molybdenum in an amount of 7 wt% or more, nickel in an amount of 45 wt% or more, and chromium in an amount of 3 wt% or more. The resistive layer still more preferably contains molybdenum in an amount of 9 wt% or more, nickel in an amount of 47 wt% or more, and chromium in an amount of 5 wt% or more. The resistive layer yet more preferably contains molybdenum in an amount of 11 wt% or more, nickel in an amount of 50 wt% or more, and chromium in an amount of 10 wt% or more. The resistive layer particularly preferably contains molybdenum in an amount of 13 wt% or more, nickel in an amount of 53 wt% or more, and chromium in an amount of 12 wt% or more. The resistive layer very preferably contains molybdenum in an amount of 15 wt% or more, nickel in an amount of 55 wt% or more, and chromium in an amount of 15 wt% or more. The resistive layer most preferably contains molybdenum in an amount of 16 wt% or more, nickel in an amount of 57 wt% or more, and chromium in an amount of 16 wt% or more. Additionally, the nickel content in the resistive layer is preferably 80 wt% or less, more preferably 70 wt% or less, and still more preferably 65 wt% or less. The chromium content is preferably 50 wt% or less, more preferably 40 wt% or less, and still more preferably 35 wt% or less.

The resistive layer may further contain metals other than molybdenum, nickel, or chromium. Examples of such metals include iron, cobalt, tungsten, manganese, and titanium. The upper limit of the total content of metals other than molybdenum, nickel, and chromium in the resistive layer containing molybdenum, nickel, and chromium is preferably 45 wt%, more preferably 40 wt%, still more preferably 35 wt%, yet more preferably 30 wt%, particularly preferably 25 wt%, and very preferably 23 wt% from the standpoint of durability of the resistive layer. The lower limit of the total content of metals other than molybdenum, nickel, and chromium is, for example, 1 wt%.

When the resistive layer contains iron, the upper limit of the content of iron is preferably 25 wt%, more preferably 20 wt%, and still more preferably 15 wt%, with the lower limit being preferably 1 wt%, from the standpoint of durability of the resistive layer. When the resistive layer contains cobalt and/or manganese, the upper limit of the content of each metal is independently preferably 5 wt%, more preferably 4 wt%, and still more preferably 3 wt%, with the lower limit being preferably 0.1 wt%, from the standpoint of durability of the resistive layer. When the resistive layer contains tungsten, the upper limit of the content of tungsten is preferably 8 wt%, more preferably 6 wt%, and still more preferably 4 wt%, with the lower limit being preferably 1 wt%, from the standpoint of durability of the resistive layer.

The resistive layer may contain silicon and/or carbon. The resistive layer containing silicon and/or carbon contains silicon and/or carbon in an individual amount of preferably 1 wt% or less, and more preferably 0.5 wt% or less. The resistive layer containing silicon and/or carbon contains silicon and/or carbon in an individual amount of preferably 0.01 wt% or more.

### 1-4-2. Barrier Layer of Resistive Film

From the standpoint of durability, the resistive film preferably has a barrier layer. The barrier layer is disposed on at least one surface of the resistive layer. The barrier layer is described in detail below.

The barrier layer can be any layer that can protect the resistive layer, and that can suppress degradation of the resistive layer. The material of the barrier layer can be, for example, a metal compound or a metalloid compound; and preferably, for example, an oxide, a nitride, or a nitride oxide of metal or metalloid. The barrier layer may contain components other than these materials, to the extent that the effect of the present invention is not significantly impaired. In this case, the content of the material described above in the barrier layer is, for example, 80 mass% or more, preferably 90 mass% or more, more preferably 95 mass% or more, and still more preferably 99 mass% or more; and typically less than 100 mass%.

Examples of metal elements contained in the barrier layer include titanium, aluminum, niobium, cobalt, and nickel. Examples of metalloid elements contained in the barrier layer include silicon, germanium, antimony, and bismuth.

Examples of the oxide above include compounds represented by MOx wherein X represents a number that satisfies the formula: n/100 ≤ X ≤ n/2 (n representing the valence of a metal or metalloid), and M represents a metal element or metalloid element.

Examples of the nitride above include compounds represented by MN_{Y} wherein Y represents a number that satisfies the formula: n/100 ≤ Y ≤ n/3 (n representing the valence of a metal or metalloid), and M represents a metal element or metalloid element.

Examples of the nitride oxide above include compounds represented by MO_{X}N_{Y} wherein X and Y satisfy the formula: n/100 ≤ X, n/100 ≤ Y, and X + Y ≤ n/2 (n representing the valence of a metal or metalloid), and M represents a metal element or metalloid element.

Regarding the oxidation number X of the oxide or nitride oxide, for example, elemental analysis of the cross-sectional surface of a layer containing MOx or MOxN_{Y} is performed with an FE-TEM-EDX (e.g., JEM-ARM200F produced by JEOL, Ltd.), and then X is calculated from the element ratio of M and O per area of the cross-sectional surface of the layer containing MOx or MOxN_{Y}. From this calculation, the valence of the oxygen atom can be determined.

Regarding the nitridation number Y of the nitride or nitride oxide, for example, elemental analysis of the cross-sectional surface of a layer containing MN_{Y} or MOxN_{Y} is performed with an FE-TEM-EDX (e.g., JEM-ARM200F produced by JEOL, Ltd.), and then Y is calculated from the element ratio of M and N per area of the cross-sectional surface of the layer containing MN_{Y} or MOxN_{Y}. From this calculation, the valence of the nitrogen atom can be determined.

Specific examples of materials of the barrier layer include SiO₂, SiOₓ, Al₂O₃, MgAl₂O₄, CuO, CuN, TiO₂, TiN, and AZO (aluminum-doped zinc oxide).

The thickness of the barrier layer can be any value. The thickness of the barrier layer is, for example, 1 nm or more and 200 nm or less, preferably 1 nm or more and 100 nm or less, and more preferably 1 nm or more and 20 nm or less.

The layer structure of the barrier layer is not particularly limited. The barrier layer may be composed of a single barrier layer, or a combination of two or more barrier layers.

### 1-5. Layer Structure

In the radio wave absorber of the present invention, the layers are arranged in such an order as to enable the radio wave absorber to exhibit radio wave absorption performance. The base material, the dielectric layer, and the reflective layer are disposed in this order. When the radio wave absorber of the present invention is used as a λ/4 type radio wave absorber (i.e., when further comprising a resistive film), the base material, the resistive film, the dielectric layer, and the reflective layer are disposed in this order.

The radio wave absorber of the present invention may contain an additional layer in addition to the base material, the dielectric layer, and the reflective layer (or in addition to the base material, the resistive film, the dielectric layer, and the reflective layer). The additional layer can be disposed on one surface of the base material, the resistive film, the dielectric layer, and/or the reflective layer.

Examples of the additional layer include an adhesive layer disposed on the uppermost surface on the side opposite to the dielectric layer side of the reflective layer. The adhesive layer allows the radio wave absorber of the present invention to be more easily attached to another member (e.g., a device in an automobile). From this standpoint, the radio wave absorber of the present invention preferably comprises an adhesive layer on the surface of the reflective layer on the side opposite to the dielectric layer side.

Additionally, it is preferred to use, for example, a barrier layer having gas barrier properties as the additional layer. Examples include a barrier layer disposed on the surface of the reflective layer on the side opposite to the dielectric layer side. The layer structure of the barrier layer is the same as that of the barrier layer of the base material.

Examples of adhesives include, but are not particularly limited to, acrylic adhesives, urethane adhesives, polyolefin adhesives, polyester adhesives, vinyl alkyl ether adhesives, polyamide adhesives, rubber adhesives, silicone adhesives, and fluorine-containing adhesive.

### 1-6. Performance

The radio wave absorber of the present invention is preferably capable of exhibiting performance such that the absorption of electromagnetic waves at 79 GHz after a flowing mixed gas corrosion test is 20 dB or more. The absorption is preferably 23 dB or more, and more preferably 25 dB or more. The upper limit of the absorption may be any value, and is, for example, 50 dB or 60 dB.

The performance can be measured as follows. Specifically, a radio wave absorption measurement device is constructed using an MS4647B network analyzer (produced by Anritsu Corporation) and a BD1-26.A free space material measurement device (produced by Keycom Corporation). By using this radio wave absorption measurement device, the radio wave absorption at 79 GHz of the radio wave absorber can be measured according to JIS R1679. The radio wave absorber is set so that the direction of radio wave incidence is vertical and from the opposite side of the reflective layer.

### 1-7. Production Method

The radio wave absorber of the present invention can be obtained in accordance with or based on various methods, such as known production methods, depending on its structure. For example, the radio wave absorber of the present invention can be obtained by a method comprising stacking a resistive film, as required, on a base material, and then stacking a dielectric layer and a reflective layer in this order.

The method for stacking layers can be any method.

The resistive film and the barrier layer can be stacked, for example, by sputtering, vacuum deposition, ion plating, chemical vapor deposition, or pulsed laser deposition. Of these, from the standpoint of film thickness controllability, sputtering is preferable. The sputtering can be of any type; examples include DC magnetron sputtering, high-frequency magnetron sputtering, and ion beam sputtering. The sputtering device may be of a batch system, or a roll-to-roll system.

The dielectric layer and the reflective layer can be stacked, for example, by using the adhesiveness of the dielectric layer.

### 2. Application

Due to its ability to absorb undesired electromagnetic waves, the radio wave absorber according to the present invention can be suitably used as an optical transceiver or a member for countermeasure against radio waves in, for example, next-generation mobile communications systems (5G), short-distance wireless transfer techniques, and the like. Alternatively, the radio wave absorber according to the present invention can be used in order to reduce radio wave interference and noise in an intelligent transport system (ITS) that communicates between automobiles, roads, and people; and in millimeter-wave radars for automobile collision prevention systems.

In one embodiment, the present invention relates to a molded product equipped with a radio wave absorber, comprising a molded product and the radio wave absorber of the present invention attached to the molded product. Examples of molded products include components used in the various applications described above. Examples of the method of attaching the radio wave absorber of the present invention to a molded product can be any method. For example, the attachment can be performed through an adhesive or by means of a fixture. Preferred examples of the molded product equipped with a radio wave absorber include millimeter-wave radars.

The radio wave frequency targeted by the radio wave absorber of the present invention is preferably 10 to 150 GHz, more preferably 20 to 120 GHz, still more preferably 30 to 100 GHz, even more preferably 55 to 90 GHz, and particularly preferably 70 to 90 GHz.

### Examples

The present invention is described in detail below with reference to Examples. However, the present invention is not limited to the Examples.

### (1) Production of Radio Wave Absorber

### (1-1) Production of radio wave absorber using magnetic loss

### Example 1

An SiO₂ layer (average thickness: 28 nm) was formed as a barrier layer on the surface of a 50 µm-thick polyethylene terephthalate (PET) film (relative permittivity: 3.1) (Ester Film A4100, produced by Toyobo Co., Ltd.) by pulsed DC sputtering at an output of 1.0 kW by introducing Ar gas at a flow rate of 100 sccm and oxygen gas at a flow rate of 10 sccm and adjusting the pressure to 0.12 Pa, thus obtaining a base material.

300 parts by mass of YW1 carbonyl iron powder (produced by New Metals and Chemicals Corporation, Ltd.) was added to 100 parts by mass of Evaflex EV250 (produced by Du Pont-Mitsui Polychemicals Co., Ltd.) and mixed with a mixing roll. The resulting product was then press-molded with heating at 120°C to produce a dielectric layer (thickness: 1200 µm, relative permittivity: 6.60). One surface of this dielectric layer was bonded to a 12 µm-thick copper foil (produced by Fukuda Metal Foil & Powder Co., Ltd.), and the surface of the base material on the side on which the SiO₂ layer was formed was bonded to the surface of the dielectric layer on the side opposite to the side on which the copper foil was bonded, thus obtaining a radio wave absorber that used magnetic loss.

### Examples 2 to 4 and Comparative Examples 1 to 3

Radio wave absorbers that used magnetic loss were obtained in the same manner as in Example 1, except that the thickness of the barrier layer of the base material, the type of metal in the reflective layer, the thickness of the reflective layer, etc., were changed as shown in the table below.

### Example 5

A radio wave absorber that used magnetic loss was obtained in the same manner as in Example 1, except that the base material, the type of metal in the reflective layer, the thickness of the reflective layer, etc., were changed as shown in the table below. The titanium oxide-containing PET base material was prepared as follows.

10 wt% of titanium oxide (average particle size: 200 nm, trade name: ST-41, produced by Ishihara Sangyo Kaisha, Ltd.) was added to polyethylene terephthalate, and melted and extruded at 280°C. The resulting product was cooled and solidified to obtain an unstretched film. The unstretched film was stretched 3-fold at 100°C in the longitudinal direction and 3.3-fold at 120°C in the traverse direction, followed by heat treatment, thus obtaining a titanium oxide particle-containing PET base material with a thickness of 50 µm.

### (1-2) Production of λ/4 type radio wave absorber

### Example 6

An SiO₂ layer (average thickness: 28 nm) was formed as barrier layer 1 on the surface of a 50 µm-thick polyethylene terephthalate (PET) film (relative permittivity: 3.1) (Ester Film A4100, produced by Toyobo Co., Ltd.) by pulsed DC sputtering at an output of 1.0 kW by introducing Ar gas at a flow rate of 100 sccm and oxygen gas at a flow rate of 10 sccm and adjusting the pressure to 0.12 Pa, thus obtaining a base material.

A resistive film having a surface resistance value of 372 Ω/□ (resistive layer/barrier layer 2) was formed on the surface of barrier layer 1 of the base material as follows. First, a resistive layer was formed by pulsed DC sputtering. Sputtering was performed using Hastelloy C-276 as a target and at an output of 0.4 kW by introducing Ar gas at a flow rate of 100 sccm and adjusting the pressure to 0.12 Pa. Next, an SiO₂ layer (average thickness: 5 nm) was formed as barrier layer 2 on the resistive layer by pulsed DC sputtering using silicon as a target and at an output of 1.0 kW by introducing Ar gas at a flow rate of 100 sccm and oxygen gas at a flow rate of 10 sccm, and under the conditions of a pressure of 0.12 Pa.

Subsequently, a dielectric formed of a two-sided acrylic adhesive tape with a thickness of 500 um and a relative permittivity of 2.6 was stacked on the formed resistive film. Then, a reflective layer formed of copper with a thickness of 30 µm was further stacked on the dielectric, thus obtaining a λ/4 type radio wave absorber.

### Examples 7 to 10 and Comparative Examples 4 to 6

Λ/4 radio wave absorbers were obtained in the same manner as in Example 6, except that the thickness of the barrier layer of the base material, the presence or absence of the barrier layer in the base material, the type of metal in the reflective layer, and the thickness of the reflective layer, etc., were changed as shown in the table below.

### (2) Measurement of Physical Properties

### (2-1) Measurement of water vapor transmission rate of base material

A water vapor transmission test was performed using a PERMATRAN-W 3/33 water vapor transmission rate testing system (produced by Mocon, Inc.). The measurement was performed by a method according to JIS K7129:2019 at a test temperature of 40°C and a test humidity of 90% RH, with the barrier layer side being on the detector side.

### (2-2) Measurement of resistance value of reflective layer after a flowing mixed gas corrosion test

The produced radio wave absorber was placed in the test chamber of a KG120(N) gas corrosion tester (produced by Fact k Co., Ltd.), and a flowing mixed gas corrosion test was carried out at a temperature of 35°C, a humidity of 75% RH, and a test duration of 240 hours by adjusting the gas concentrations, i.e., hydrogen sulfide: 0.1 ppm, sulfur dioxide: 2.0 ppm, nitrogen dioxide: 2.0 ppm, and chlorine: 0.1 ppm, based on Method 4 of IEC60068-2-60:2015. After the test, the radio wave absorber was removed, and a probe was brought into contact with the surface of the reflective layer of the radio wave absorber on the side opposite to the dielectric side to measure the resistance value by an eddy current method using a non-contact resistance measurement instrument (trade name: EC-80P, produced by Napson Corporation; or an equivalent product).

### (3) Evaluation of durability of radio wave absorber against corrosive gases

A radio wave absorption measurement device was constructed using an MS4647B network analyzer (produced by Anritsu Corporation) and a BD1-26.A free space material measurement device (produced by Keycom Corporation). By using this radio wave absorption measurement device, the radio wave absorption at 79 GHz of the radio wave absorber after the flowing mixed gas corrosion test was measured according to JIS R1679. The radio wave absorber was set so that the direction of radio wave incidence was vertical and from the opposite side of the reflective layer. A radio wave absorption of 23 dB or more was evaluated to be A, a radio wave absorption of 20 dB or more and less than 23 dB was evaluated to be B, a radio wave absorption of less than 20 dB was evaluated to be C.

### (4) Results

Tables 1 and 2 show the results.

**Table 1**

| | | Example | | | | | Comparative Example | | |
|---|---|---|---|---|---|---|---|---|---|
| | | 1 | 2 | 3 | 4 | 5 | 1 | 2 | 3 |
| Base material | Thickness (µm) | 50 | 50 | 50 | 50 | 50 | 50 | 50 | 50 |
| | Material of support | PET | PET | PET | PET | Titanium oxide particle-containing PET | PET | PET | PET |
| | Thickness of barrier layer (nm) | 35 | 12 | 18 | 18 | - | 5 | 35 | 9 |
| | Relative permittivity | 3.1 | 3.1 | 3.1 | 3.1 | 3.4 | 3.1 | 3.1 | 3.1 |
| | Water vapor transmission rate (g/(m²•day)) | 1.5 | 4.8 | 2.9 | 2.9 | 4.5 | 7.1 | 1.5 | 5.6 |
| Dielectric | Material | Acrylic adhesive/carbonyl iron powder | | | | | | | |
| | Relative permittivity | 6.6 | 6.6 | 6.6 | 6.6 | 2.6 | 6.6 | 6.6 | 6.6 |
| | Thickness (µm) | 1200 | 1200 | 1200 | 1200 | 500 | 1200 | 1200 | 1200 |
| Reflective layer | Type | Cu | Cu | Cu | Cr | Cu | Cu | Cu | Al |
| | Thickness (µm) | 12 | 12 | 8 | 8 | 30 | 12 | 5 | 5 |
| | Resistance value after flowing mixed gas corrosion test (Ω/□) | 30 | 30 | 99 | 2 | 1.5 | 30 | 105 | 1000 |
| Evaluation | Durability against corrosive gases | A | B | B | A | B | C | C | C |

**Table 2**

| | | Example | | | | | Comparative Example | | |
|---|---|---|---|---|---|---|---|---|---|
| | | 6 | 7 | 8 | 9 | 10 | 4 | 5 | 6 |
| Base material | Thickness (µm) | 50 | 50 | 50 | 50 | 50 | 50 | 50 | 50 |
| | Material of support | PET | PET | PET | PET | PET | PET | PET | PET |
| | Thickness of barrier layer (nm) | 35 | 68 | 12 | 35 | 35 | 9 | - | 3 |
| | Relative permittivity | 3.1 | 3.1 | 3.1 | 3.1 | 3.1 | 3.1 | 3.1 | 3.1 |
| | Water vapor transmission rate (g/( m²•day)) | 1.5 | 0.7 | 4.8 | 1.5 | 1.5 | 5.6 | 12.0 | 8.5 |
| Resistive film | Metal type | Hastelloy | | | | | | | ITO |
| | Resistance value | 372 | 372 | 372 | 372 | 372 | 372 | 372 | 372 |
| Dielectric | Material | Acrylic resin | | | | | | | |
| | Relative permittivity | 2.6 | 2.6 | 2.6 | 2.6 | 2.6 | 2.6 | 2.6 | 2.6 |
| | Thickness (µm) | 500 | 500 | 500 | 500 | 500 | 500 | 500 | 500 |
| Reflective layer | Type | Cu | Cu | Cu | Cr | Cu | Cu | Cu | Cu |
| | Thickness (µm) | 30 | 12 | 9 | 7 | 12 | 30 | 6 | 6 |
| | Resistance value after flowing mixed gas corrosion test (Ω/□) | 1.5 | 30 | 90 | 20 | 30 | 1.5 | 150 | 150 |
| Evaluation | Durability against corrosive gases | A | B | B | A | B | C | C | C |

### Description of the Reference Numerals

1 base material
2 resistive film
3 dielectric layer
4 reflective layer
5 adhesive layer
6 molded product

## Claims

1. A radio wave absorber comprising a base material, a dielectric layer, and a reflective layer,
the base material, the dielectric layer, and the reflective layer being stacked in this order,
the base material having a water vapor transmission rate of 5 g/ (m²•day) or less,
the reflective layer having a resistance value after a flowing mixed gas corrosion test of 100 Ω/□ or less.

2. The radio wave absorber according to claim 1, wherein the base material comprises a support and a barrier layer, and wherein the barrier layer is disposed between the support and the dielectric layer.

3. The radio wave absorber according to claim 1 or 2, wherein the reflective layer has a thickness of 8 µm or more.

4. The radio wave absorber according to any one of claims 1 to 3, wherein the reflective layer contains at least one metal selected from the group consisting of nickel, chromium, molybdenum, and tantalum.

5. The radio wave absorber according to any one of claims 1 to 4, wherein the absorption of electromagnetic waves at 79 GHz after a flowing mixed gas corrosion test is 20 dB or more.

6. The radio wave absorber according to any one of claims 1 to 5, which further comprises a resistive film and is a λ/4 type radio wave absorber.

7. The radio wave absorber according to claim 6, wherein the base material, the resistive film, the dielectric layer, and the reflective layer are stacked in this order.

8. The radio wave absorber according to any one of claims 1 to 5, wherein the dielectric layer contains magnetic particles.

9. A molded product equipped with a radio wave absorber, comprising the radio wave absorber of any one of claims 1 to 8.

10. A millimeter-wave radar comprising the radio wave absorber of any one of claims 1 to 8.
